(19) Europäisches Patentamt
European Patent Office
Office européen des brevets

(11) EP 4 057 019 A1

(12) EUROPEAN PATENT APPLICATION
published in accordance with Art. 153(4) EPC

(43) Date of publication:
14.09.2022 Bulletin 2022/37

(51) International Patent Classification (IPC):
G01R 31/392 $^{(2019.01)}$     B60L 58/16 $^{(2019.01)}$
B60L 58/12 $^{(2019.01)}$

(21) Application number: 20885366.3

(22) Date of filing: 31.12.2020

(52) Cooperative Patent Classification (CPC):
B60L 58/12; B60L 58/16; G01R 31/392;
Y02T 10/70

(86) International application number:
PCT/CN2020/142035

(87) International publication number:
WO 2021/089062 (14.05.2021 Gazette 2021/19)

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
KH MA MD TN

(30) Priority: 05.11.2019 CN 201911068427
31.12.2019 CN 201911413797

(71) Applicants:
• Aulton New Energy Automotive Technology Group
Guangzhou, Guangdong 510700 (CN)

• Shanghai Dianba New Energy Technology Co., Ltd.
Shanghai 201308 (CN)

(72) Inventor: ZHANG, Chao
Shanghai 201315 (CN)

(74) Representative: Bittner, Bernhard
Hannke Bittner & Partner
Patent- und Rechtsanwälte mbB
Prüfeninger Strasse 1
93049 Regensburg (DE)

(54) **METHOD AND SYSTEM FOR MANAGING LIFE CYCLE OF QUICK-CHANGE ELECTRIC CAR BATTERY PACK, METHOD AND SYSTEM FOR ACQUIRING BATTERY HEALTH, DEVICE, AND READABLE STORAGE MEDIUM**

(57) A method and a system for managing the life cycle of a quick-change electric car battery pack, the method comprising the following steps: receiving a battery data report sent out by a station (S101); analyzing the battery data report and thereby acquiring identification codes and operation information corresponding to battery packs (S102); and on the basis of the identification codes, performing corresponding storage on all received operation information (S103). The present invention makes possible complete recording for each quick-change electric car battery pack from entry into a battery swapping network to departure from the battery swapping network, and specifically makes possible recording and storage of network entry, battery swapping, charging, maintenance, and departure operations, ultimately forming a complete life cycle record for the battery packs. On the basis of the complete life cycle record, transparent management of battery pack source traceability, destination traceability, and node controllability is made possible, thereby effectively extending the service life of battery packs, and establishing a sound basis for battery safety controllability and data traceability.

Start

| Receive a battery data message sent by a station side | S101 |
| Parse the battery data message to obtain an identification code and operation information of a corresponding battery pack | S102 |
| Correspondingly store all the pieces of received operation information on the basis of the identification code | S103 |
| Identify state information of each battery pack on the basis of the operation information, the state information including one of a normally used state, a repaired state and a retired state | S104 |
| Obtain SOH information of the battery pack on the basis of all the pieces of obtained battery pack charging information | S105 |

End

Fig. 1

EP 4 057 019 A1

## Description

This application claims the priority of Chinese patent application No. 201911413797.7 filed on December 31, 2019 and Chinese patent application No. 201911068427.4 filed on November 5, 2019, which is hereby incorporated by reference in its entirety.

## Technical Field

The present invention relates to the field of new energy vehicles, in particular to a method and system for managing a full life cycle of a battery pack for a quick-swapping electric vehicle, a method and system for obtaining a State of Health (SOH) of a battery, a device, and a readable storage medium.

## Background

At present, the new energy vehicle industry is being vigorously developed. As one of the three important components of a new energy vehicle, a battery pack for a quick-swapping electric vehicle provides power for the entire vehicle, allowing users to use the electric vehicle as easily as a fuel vehicle and to supplement energy is as conveniently as refueling. At present, the management and control requirements for the life cycle of a battery pack are getting higher and higher. How to make a battery pack safe, reliable and traceable in real time is a difficulty faced by all new energy companies and needing be solved.

At present, a power battery pack is a power source of an electric vehicle. The monitoring and management of batteries is particularly important for stable and efficient operation of the electric vehicle. An important indicator of a battery is a State of Health (SOH) of the battery. SOH is used for representing the capacity, state of health and performance state of a storage battery. In brief, SOH is a ratio of a performance parameter to a nominal parameter after a battery is used for a period of time. The calculation of an SOH value is achieved on the basis of a ratio of a capacity released by a battery from a fully charged state to cut-off voltage at a certain rate to the corresponding nominal capacity. At the present, the SOH is basically obtained by the above method on the basis of a laboratory. In this solving method, the charging process of a battery is regarded as being constant. However, it is found through analysis that the charging process of any battery is not constant, which leads to the inaccuracy of a result of an existing SOH value. How to obtain an accurate SOH value, timely understand the current SOH of a battery, and predict the future attenuation of a battery is of great significance for the use of electric vehicles.

## Content of the present invention

The technical problem to be solved in the present invention is to overcome the shortcomings of poor traceability and low reliability caused by insufficient effective management and control for the life cycle of a battery pack for a quick-swapping electric vehicle and to provide a method and system for managing a full life cycle of a battery pack for a quick-swapping electric vehicle, a method and system for obtaining an SOH of a battery, a device, and a readable storage medium, which can achieve source-verifiable, direction-traceable and node-controllable transparent management for a battery pack, thus effectively prolonging the service life of the battery pack.

The present invention solves the above technical problems through the following technical solutions:

The present invention provides a method for managing a full life cycle of a battery pack for a quick-swapping electric vehicle, including the following steps:

receiving a battery data message sent by a station side;

parsing the battery data message to obtain an identification code and operation information of a corresponding battery pack; and

correspondingly storing all the pieces of received operation information on the basis of the identification code.

Preferably, the operation information includes at least one of battery pack registration information, battery pack swapping information, battery pack charging information, battery pack repair information and battery pack retirement information;

when the battery pack enters a battery swapping network for the first time, the battery pack registration information is generated at least on the basis of the identification code of the battery pack;

when the battery pack is subjected to a battery swapping operation in the battery swapping network, corresponding battery swapping information is recorded, and the battery pack swapping information is generated;

when the battery pack is subjected to a charging operation in the battery swapping network, corresponding charging information is obtained, and the battery pack charging information is generated;

health information of the battery pack is obtained on the basis of the swapping information and the charging information; a battery state of the battery pack is determined on the basis of the health information: when the battery state indicates that a battery is faulted and the battery pack enters a repair flow, generating the battery pack repair information; and when the battery state is to be retired and the battery pack enters a retirement flow, generating the battery pack retirement information.

Preferably, the method for managing the full life cycle further includes:
identifying state information of each battery pack on the basis of the operation information, the state information including one of a normally used state, a repaired state and a retired state.

Preferably, the battery pack charging information includes current power consumption data and charging process data;

the method for managing the full life cycle further includes:

verifying the current power consumption data according to the charging process data, thus billing, on the basis of the current power consumption data, during the battery swapping.

Preferably, the method for managing the full life cycle further includes:
obtaining transfer path information of the battery pack on the basis of all the pieces of obtained battery pack swapping information of the battery pack.

Preferably, the method for managing the full life cycle further includes:
obtaining state of charging information of the battery pack on the basis of all the pieces of obtained battery pack charging information of the battery pack.

Preferably, the step of obtaining state of charging information of the battery pack on the basis of all the pieces of obtained battery pack charging information of the battery pack includes:

building one SOC table, the SOC table storing SOC data of batteries of different battery models in charging processes at different mileages;

obtaining a piece of battery information of a target rechargeable battery, the battery information including a battery model and current mileage of the target rechargeable battery;

obtaining, according to the battery information and the SOC table, target SOC data corresponding to the target rechargeable battery;

obtaining current charging data of the target rechargeable battery within a charging time period, the current charging data including a current charging quantity and current SOC data within the charging time period;

correcting the current SOC data according to the target SOC data; and

calculating a current SOH of the target rechargeable battery according to the corrected current charging data.

Preferably, the SOC data is SOC data of a single battery under a single charging cycle, and the step of building one SOC table includes:

averagely dividing the charging cycle into a plurality of unit charging cycles;

respectively calculating, on the basis of an integral power algorithm, unit SOC data corresponding to each unit charging cycle in the charging process; and

building the SOC table according to all the unit SOC data.

Preferably, the current SOC data includes a charging start SOC and a charging end SOC, and the step of correcting the current SOC data according to the target SOC data specifically includes:

extracting target unit SOC data between unit SOC data corresponding to the charging start SOC and unit SOC data corresponding to the charging end SOC from the target SOC data; and
correcting a difference between the charging start SOC and the charging end SOC according to the target unit SOC data.

Preferably, the obtaining method solves the current SOH by the following formula, which specifically includes:

$$SOH_d = \frac{Q_{charged}}{(SOC_E - SOC_S)_X} * Q_{rated}$$

$$(SOC_E - SOC_S)_X = (SOC_E - SOC_{n-1}) + (SOC_{n-1} - SOC_{n-2}) + \cdots + (SOC_1 - SOC_S)$$

where $SOH_d$ is the current SOH; Qcharged is the current charging quantity; $SOC_E$ is a charging end SOC; $SOC_S$ is a charging start SOC; $(SOC_E - SOC_S)_X$ is a corrected current SOC data; $Q_{rated}$ is a known rated power; n is the number of unit charging cycles included in the charging time period; and $SOC_{n-1}$ is a corresponding SOC of the nth unit charging cycle of the target rechargeable battery from the start of charging to the end of charging, which is obtained by querying the SOC table.

Preferably, the station side includes: a battery swapping station for swapping the battery pack of the electric vehicle, a charging station for charging the removed battery pack, and a repair station for repairing the battery pack.

The present invention further provides an electronic device, including a memory, a processor, and a computer program stored in the memory and operable on the processor. When the processor executes the computer program, the above-mentioned method for managing a full life cycle of a battery pack for a quick-swapping electric vehicle is implemented.

The present invention further provides a computer-readable storage medium which stores a computer program. When the program is executed by a processor, the steps of the above-mentioned method for managing a full life cycle of a battery pack for a quick-swapping electric vehicle are executed.

The present invention further provides a system for managing a full life cycle of a battery pack for a quick-swapping electric vehicle, including:

a receiving module configured for receiving a battery data message sent by a station side;

a parsing module configured for parsing the battery data message to obtain an identification code and operation information of a corresponding battery pack; and

a storage module configured for correspondingly storing all the pieces of received operation information on the basis of the identification code.

Preferably, the operation information includes at least one of battery pack registration information, battery pack swapping information, battery pack charging information, battery pack repair information and battery pack retirement information.

The system for managing the full life cycle further includes:

a registration information generation module configured for, when the battery pack enters a battery swapping network for the first time, generating the battery pack registration information at least on the basis of the identification code of the battery pack;

a battery swapping information generation module configured for, when the battery pack is subjected to a battery swapping operation in the battery swapping network, recording corresponding battery swapping information, and generating the battery pack swapping information;

a charging information generation module configured for, when the battery pack is subjected to a charging operation in the battery swapping network, obtaining corresponding charging information, and generating the battery pack charging information;

a health information generation module configured for obtaining, on the basis of the swapping information and the charging information, health information of the battery pack; and

a determination module configured for determining, on the basis of the health information, a battery state of the battery pack: when the battery state indicates that a battery is faulted and the battery pack enters a repair flow, generating the battery pack repair information; and when the battery state is to be retired and the battery pack enters a retirement flow, generating the battery pack retirement information.

Preferably, the system for managing the full life cycle further includes:
a state information generation module configured for identifying state information of each battery pack on the basis of the operation information, the state information including one of a normally used state, a repaired state and a retired state.

Preferably, the battery pack charging information includes current power consumption data and charging process data;

the system for managing the full life cycle further includes:

a verification module configured for verifying the current power consumption data according to the charging process data, thus billing, on the basis of the current power consumption data, during the battery swapping.

Preferably, the system for managing the full life cycle further includes:
a transfer path information generation module configured for obtaining transfer path information of the battery pack on the basis of all the pieces of obtained battery pack swapping information of the battery pack.
Preferably, the system for managing the full life cycle further includes:
an SOH information generation module configured for obtaining state of charging information of the battery pack on the basis of all the pieces of obtained battery pack charging information of the battery pack.
Preferably, the SOH information generation module specifically includes an SOC table building module, a battery information obtaining module, a target SOC data obtaining module, a current charging data obtaining module, a correction module and an SOH obtaining module;

the SOC table building module is configured for building one SOC table, the SOC table storing SOC data of batteries of different battery models in charging processes at different mileages;

the battery information obtaining module is configured for obtaining a piece of battery information of a target rechargeable battery, the battery information including a battery model and current mileage of the target rechargeable battery;

the target SOC data obtaining module is configured for obtaining, according to the battery information and the SOC table, target SOC data corresponding to the target rechargeable battery;

the current charging data obtaining module configured for obtaining current charging data of the target rechargeable battery within a charging time period, the current charging data including a current charging quantity and current SOC data within the charging time period;

the correction module is configured for correcting the current SOC data according to the target SOC data; and

the SOH obtaining module is configured for calculating a current SOH of the target rechargeable battery according to the corrected current charging data.

Preferably, the SOC data is SOC data of a single battery under a single charging cycle, and the SOC table building module includes a cycle division element, a unit data obtaining element and a building element;

the cycle division element is configured for averagely dividing the charging cycle into a plurality of unit charging cycles;
the unit data obtaining element is configured for respectively calculating, on the basis of an integral power algorithm, unit SOC data corresponding to each unit charging cycle in the charging process; and
the building element is configured for building the SOC table according to all the unit SOC data.

Preferably, the current SOC data includes a charging start SOC and a charging end SOC;
the correction module is configured for extracting target unit SOC data between unit SOC data corresponding to the charging start SOC and unit SOC data corresponding to the charging end SOC from the target SOC data; and correcting a difference between the charging start SOC and the charging end SOC according to the target unit SOC data.

Preferably, the obtaining system solves the current SOH by the following formula, which specifically includes:

$$SOH_d = \frac{Q_{charged}}{(SOC_E - SOC_S)_X} * Q_{rated}$$

$$(SOC_E - SOC_S)_X = (SOC_E - SOC_{n-1}) + (SOC_{n-1} - SOC_{n-2}) + \cdots + (SOC_1 - SOC_S)$$

where $SOH_d$ is a current SOH; $Q_{charged}$ is a current charging quantity; $SOC_E$ is a charging end SOC; $SOC_S$ is a charging start SOC; $(SOC_E - SOC_S)_X$ is a corrected current SOC data; $Q_{rated}$ is a known rated power; n is the number of unit charging cycles included in the charging time period; and $SOC_{n-1}$ is a corresponding SOC of the nth unit charging cycle of the target rechargeable battery from the start of charging to the end of charging, which is obtained by querying the SOC table.

Preferably, the station side includes: a battery swapping station for swapping the battery pack of the electric vehicle, a charging station for charging the removed battery pack, and a repair station for repairing the battery pack.

The present invention has positive progressive results:

The present invention achieves a full record of the battery pack of each quick-swapping electric vehicle from entering the battery swapping network to leaving the battery swapping network, which specifically recording and storing entry, battery swapping, charging, repair, and retirement operations, thus finally forming a record of a full life cycle of a battery pack. On the basis of the record of the full life cycle, source-verifiable, direction-traceable and node-controllable transparent management for the battery pack can be achieved, thus effectively prolonging the service life of the battery pack, and laying a solid foundation for controlling the safety of the battery and tracing data.

**Brief description of the drawings**

Fig. 1 is a flow chart of a method for managing a full life cycle of a battery pack for a quick-swapping electric vehicle according to Embodiment 1 of the present invention.

Fig. 2 is a flow chart of a method for managing a full life cycle of a battery pack for a quick-swapping electric vehicle according to Embodiment 2 of the present invention.

Fig. 3 is a flow chart of a method for managing a full life cycle of a battery pack for a quick-swapping electric vehicle according to Embodiment 3 of the present invention.

Fig. 4 is a schematic diagram of modules of a system for managing a full life cycle of a battery pack for a quick-swapping electric vehicle according to Embodiment 4 of the present invention.

Fig. 5 is a flow chart of a method for obtaining an SOH of a battery according to Embodiment 5 of the present invention.

Fig. 6 is a flow chart of step 310 of a method for obtaining an SOH of a battery according to Embodiment 6 of the present invention.

Fig. 7 is an SOC curve chart of a certain battery model at a mileage of 0-50,000 km in a method for obtaining an SOH of a battery according to Embodiment 6 of the present invention.

Fig. 8 is an SOC curve chart of a certain battery model at a mileage of 50,000-100,000 km in a method for obtaining an SOH of a battery according to Embodiment 6 of the present invention.

Fig. 9 is a flow chart of step 350 of a method for obtaining an SOH of a battery according to Embodiment 6 of the present invention.

Fig. 10 is a schematic structural diagram of an electronic device according to Embodiment 7 of the present invention.

Fig. 11 is a schematic diagram of modules of a system for obtaining an SOH of a battery according to Embodiment 9 of the present invention.

Fig. 12 is a schematic module diagram of an SOC table building module in a system for obtaining an SOH of a battery according to Embodiment 10 of the present invention.

## Detailed description of the preferred embodiment

The present invention will be further described below in a manner of embodiments, but the present invention is not limited to the scope of the embodiments accordingly.

## Embodiment 1

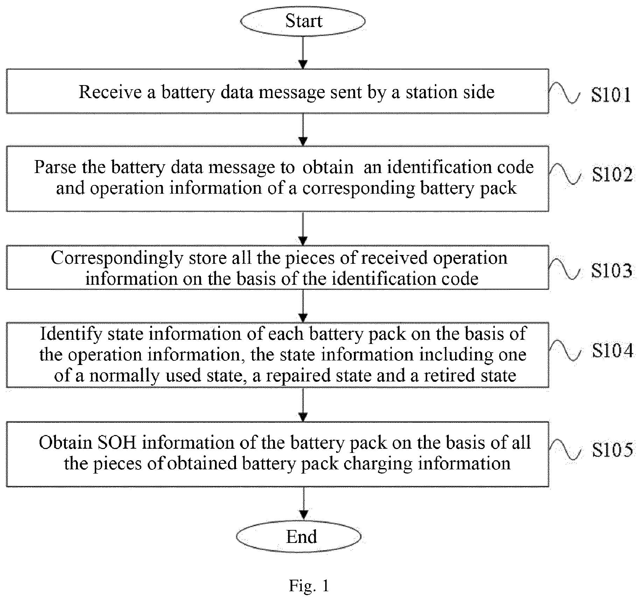

As shown in Fig. 1, this embodiment provides a method for managing a full life cycle of a battery pack for a quick-swapping electric vehicle, including the following steps.

In step S101, a battery data message sent by a station side is received.

In step S102, the battery data message is parsed to obtain an identification code and operation information of a corresponding battery pack.

The operation information includes at least one of battery pack registration information, battery pack swapping information, battery pack charging information, battery pack repair information and battery pack retirement information.

When the battery pack enters a battery swapping network for the first time, the battery pack registration information is generated at least on the basis of the identification code of the battery pack. The fact that the battery enters the battery swapping network for the first time includes that a battery pack purchased from a battery supplier is sent to the battery swapping network and that a battery pack carried on an operating vehicle is sent to the battery swapping network.

When the battery pack is subjected to a battery swapping operation in the battery swapping network, corresponding battery swapping information is recorded, and the battery pack swapping information is generated.

When the battery pack is subjected to a charging operation in the battery swapping network, corresponding battery swapping information is recorded, and the battery pack swapping information is generated.

Health information of the battery pack is obtained on the basis of the swapping information and the charging information; a battery state of the battery pack is determined on the basis of the health information: when the battery state indicates that a battery is faulted and the battery pack enters a repair flow, generating the battery pack repair information; and when the battery state is to be retired and the battery pack enters a retirement flow, generating the battery pack retirement information.

In step S 103, all the pieces of received operation information are correspondingly stored on the basis of the identification code.

In step S104, state information of each battery pack is identified on the basis of the operation information, the state information including one of a normally used state, a repaired state and a retired state.

In step S105, SOH information of the battery pack is obtained on the basis of all the pieces of obtained battery pack charging information of the battery pack. In this step, the specific obtaining process of the SOH information is as follows:

Firstly, an SOC (State of Charge) table is built according to SOC data of batteries of different battery models in charging processes at different mileages from historical charging data. A charging cycle is averagely divided into a plurality of unit charging cycles. Specifically, the entire charging process can be divided into 250 small cycles, and each unit charging cycle accounts for 0.4%. In the charging process, unit SOC data corresponding to each unit charging cycle is obtained by calculation on the basis of an integral power algorithm. That is, the SOC data is SOC data of a single battery in a single charging cycle.

Further, battery model information of a target rechargeable battery and current charging data of the target rechargeable battery within a charging time period are obtained. The current charging data includes a current charging quantity and current SOC data within the charging time period. The current SOC data includes a charging start SOC and a charging end SOC.

Further, target SOC data corresponding to the target rechargeable battery is obtained from the SOC table according to the battery model information, and the current SOC data is corrected according to the target SOC data. Specifically, target unit SOC data between unit SOC data corresponding to the charging start SOC and unit SOC data corresponding to the charging end SOC is extracted from the target SOC data; and a difference between the charging start SOC and the charging end SOC is corrected according to the target unit SOC data.

Finally, the current SOH of the target rechargeable battery is calculated according to the corrected current charging data. A calculation formula of the SOH is:

$$SOH_d = \frac{Q_{charged}}{(SOC_E - SOC_S)_X} * Q_{rated};$$

$$(SOC_E - SOC_S)_X = (SOC_E - SOC_{n-1}) + (SOC_{n-1} - SOC_{n-2}) + \cdots + (SOC_1 - SOC_S);$$

where $SOH_d$ is the current SOH; Qcharged is the current charging quantity; $SOC_E$ is the charging end SOC; $SOC_S$ is the charging start SOC; $(SOC_E - SOC_S)_X$ is the corrected current SOC data; $Q_{rated}$ is a known rated power; n is the number of unit charging cycles included in the charging time period; and $SOC_{n-1}$ is a corresponding SOC of the nth unit charging cycle of the target rechargeable battery from the start of charging to the end of charging, which is obtained by querying the SOC table.

In this embodiment, the station side includes: a battery swapping station for swapping the battery pack of the electric vehicle, a charging station for charging the removed battery pack, and a repair station for repairing the battery pack.

This embodiment achieves a full record of the battery pack of each quick-swapping electric vehicle from entering the battery swapping network to leaving the battery swapping network, which specifically recording and storing entry, battery swapping, charging, repair, and retirement operations, thus finally forming a record of a full life cycle of a battery pack. On the basis of the record of the full life cycle, source-verifiable, direction-traceable and node-controllable transparent management for the battery pack can be achieved, thus effectively prolonging the service life of the battery pack, and laying a solid foundation for controlling the safety of the battery and tracing data.

## Embodiment 2

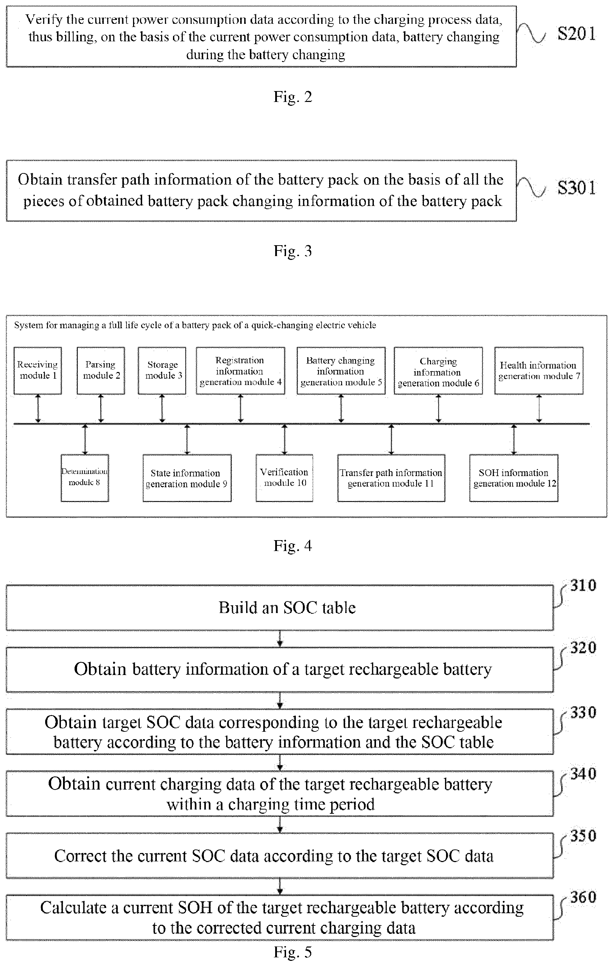

This embodiment is a further improvement on the basis of Embodiment 1. The battery pack charging information includes current power consumption data and charging process data. As shown in Fig. 2, the method for managing the full life cycle further includes the following.

In step S201, the current power consumption data is verified according to the charging process data, thus billing, on the basis of the current power consumption data, during the battery swapping. In this step, the verification process of the power consumption data is as follows.

Firstly, a plurality of pieces of charging process data submitted in the entire charging process of the battery pack, and each piece of charging process data includes a time parameter and an electric power parameter.

Further, each total intermediate charging amount is calculated according to two adjacent pieces of charging process data, and a total charging amount is calculated according to all the total intermediate charging amounts. The calculation process of each intermediate charging amount is: obtaining, according to the time parameters in the adjacent pieces of charging process data, an intermediate charging duration; obtaining, according to direct-current (DC) output voltages in the adjacent pieces of charging process data, an average DC output voltage; obtaining, according to DC output currents in the adjacent pieces of charging process data, an average DC output current; and finally, obtaining, according to the intermediate charging duration, the average DC output voltage and the average DC output current, the total intermediate charging amount through integration.

Finally, the current power consumption data is verified according to the calculated total charging amount. The current power consumption data refers to a total charging amount, submitted by a charger, for the battery pack.

In this embodiment, managing the life cycle of the battery pack further includes verifying the current power consumption data on the basis of the stored charging process data, and the current power consumption data is used as a basis for billing the battery swapping.

## Embodiment 3

This embodiment is a further improvement on the basis of Embodiment 2. As shown in Fig. 3, the method for managing the full life cycle further includes the following.

In step S301, transfer path information of the battery pack is obtained on the basis of all the pieces of obtained battery pack swapping information of the battery pack.

In this embodiment, managing the life cycle of the battery pack further includes a full record, that is, transfer path information, of transferring of the battery pack between a plurality of battery swapping stations, charging stations and repair stations of the battery swapping network. On the basis of the transfer path information, source-verifiable, direction-traceable and node-controllable transparent management for the battery pack can be further achieved, thus laying a solid foundation for controlling the safety of the battery and tracing data.

**Embodiment 4**

As shown in Fig. 4, this embodiment provides a system for managing a full life cycle of a battery pack for a quick-swapping electric vehicle, including a receiving module 1, a parsing module 2, a storage module 3, a registration information generation module 4, a battery swapping generation module 5, a charging information generation module 6, a health information generation module 7, a determination module 8, a state information generation module 9, a verification module 10, a transfer path information generation module 11 and an SOH information generation module 12.

The receiving module 1 is configured for receiving a battery data message sent by a station side. The station side includes: a battery swapping station for swapping the battery pack of the electric vehicle, a charging station for charging the removed battery pack, and a repair station for repairing the battery pack.

The parsing module 2 is configured for parsing the battery data message to obtain an identification code and operation information of a corresponding battery pack. The operation information includes at least one of battery pack registration information, battery pack swapping information, battery pack charging information, battery pack repair information and battery pack retirement information.

The storage module 3 is configured for correspondingly storing all the pieces of received operation information on the basis of the identification code.

The registration information generation module 4 is configured for, when the battery pack enters a battery swapping network for the first time, generating the battery pack registration information at least on the basis of the identification code of the battery pack.

The battery swapping information generation module 5 is configured for, when the battery pack is subjected to a battery swapping operation in the battery swapping network, recording corresponding battery swapping information, and generating the battery pack swapping information.

The charging information generation module 6 is configured for, when the battery pack is subjected to a charging operation in the battery swapping network, obtaining corresponding charging information, and generating the battery pack charging information. The battery pack charging information includes current power consumption data and charging process data.

The health information generation module 7 is configured for obtaining, on the basis of the swapping information and the charging information, health information of the battery pack.

The determination module 8 is configured for determining, on the basis of the health information, a battery state of the battery pack: when the battery state indicates that a battery is faulted and the battery pack enters a repair flow, generating the battery pack repair information; and when the battery state is to be retired and the battery pack enters a retirement flow, generating the battery pack retirement information.

The state information generation module 9 is configured for identifying state information of each battery pack on the basis of the operation information, the state information including one of a normally used state, a repaired state and a retired state.

The verification module 10 is configured for verifying the current power consumption data according to the charging process data, thus billing, on the basis of the current power consumption data, the during battery. The verification process of the power consumption data is as follows.

Firstly, a plurality of pieces of charging process data submitted in the entire charging process of the battery pack, and each piece of charging process data includes a time parameter and an electric power parameter.

Further, each total intermediate charging amount is calculated according to two adjacent pieces of charging process data, and a total charging amount is calculated according to all the total intermediate charging amounts. The calculation process of each intermediate charging amount is: obtaining, according to the time parameters in the adjacent pieces of charging process data, an intermediate charging duration; obtaining, according to direct-current (DC) output voltages in the adjacent pieces of charging process data, an average DC output voltage; obtaining, according to DC output currents in the adjacent pieces of charging process data, an average DC output current; and finally, obtaining, according to the intermediate charging duration, the average DC output voltage and the average DC output current, the total intermediate charging amount through integration.

Finally, the current power consumption data is verified according to the calculated total charging amount. The current power consumption data refers to a total charging amount, submitted by a charger, for the battery pack.

The transfer path information generation module 11 is configured for obtaining transfer path information of the battery pack on the basis of all the pieces of obtained battery pack swapping information of the battery pack.

The SOH information generation module 12 is configured for obtaining state of charging information of the battery pack on the basis of all the pieces of obtained battery pack charging information of the battery pack. The specific obtaining process of the SOH information is as follows:

Firstly, an SOC table is built according to SOC data of batteries of different battery models in charging processes at different mileages from historical charging data. A charging cycle is averagely divided into a plurality of unit charging cycles. Specifically, the entire charging process can be divided into 250 small cycles, and each unit charging cycle accounts for 0.4%. In the charging process, unit SOC data corresponding to each unit charging cycle is obtained by calculation on the basis of an integral power algorithm. That is, the SOC data is SOC data of a single battery in a single charging cycle.

Further, battery model information of a target rechargeable battery and current charging data of the target rechargeable battery within a charging time period are obtained. The current charging data includes a current charging quantity and current SOC data within the charging time period. The current SOC data includes a charging start SOC and a charging end SOC.

Further, target SOC data corresponding to the target rechargeable battery is obtained from the SOC table according to the battery model information, and the current SOC data is corrected according to the target SOC data. Specifically, target unit SOC data between unit SOC data corresponding to the charging start SOC and unit SOC data corresponding to the charging end SOC is extracted from the target SOC data; and a difference between the charging start SOC and the charging end SOC is corrected according to the target unit SOC data.

Finally, the current SOH of the target rechargeable battery is calculated according to the corrected current charging data. A calculation formula of the SOH is:

$$SOH_d = \frac{Q_{charged}}{(SOC_E - SOC_S)_X} * Q_{rated};$$

$$(SOC_E - SOC_S)_X = (SOC_E - SOC_{n-1}) + (SOC_{n-1} - SOC_{n-2}) + \cdots + (SOC_1 - SOC_S);$$

where $SOH_d$ is the current SOH; Qcharged is the current charging quantity; $SOC_E$ is the charging end SOC; $SOC_S$ is the charging start SOC; $(SOC_E - SOC_S)_X$ is the corrected current SOC data; $Q_{rated}$ is a known rated power; n is the number of unit charging cycles included in the charging time period; and $SOC_{n-1}$ is a corresponding SOC of the nth unit charging cycle of the target rechargeable battery from the start of charging to the end of charging, which is obtained by querying the SOC table.

This embodiment achieves a full record of the battery pack of each quick-swapping electric vehicle from entering the battery swapping network to leaving the battery swapping network, which specifically recording and storing entry, battery swapping, charging, repair, and retirement operations, thus finally forming a record of a full life cycle of a battery pack. On the basis of the record of the full life cycle, source-verifiable, direction-traceable and node-controllable transparent management for the battery pack can be achieved, thus effectively prolonging the service life of the battery pack, and laying a solid foundation for controlling the safety of the battery and tracing data.

**Embodiment 5**

A method for obtaining an SOH of a battery, as shown in Fig. 5, includes the following:

In step 310, an SOC table is built, the SOC table storing SOC data of batteries of different battery models in charging processes at different mileages.

In step 320, battery information of a target rechargeable battery is obtained, the battery information including a battery model and current mileage of the target rechargeable battery.

In step 330, target SOC data corresponding to the target rechargeable battery is obtained according to the battery information and the SOC table.

In step 340, current charging data of the target rechargeable battery within a charging time period is obtained. The current charging data includes a current charging quantity and current SOC data within the charging time period.

It should be noted that both a battery power and a battery capacity can be used as the basis for data calculation, and this application does not particularly limit this. The battery power is used as the basis for data calculation for illustration in this solution of the present invention.

In step 350, the current SOC data is corrected according to the target SOC data.

In step 360, a current SOH of the target rechargeable battery is calculated according to the corrected current charging data.

In this embodiment, in order to avoid a usual misunderstanding that the battery charging process is uniform, the SOC table is built on the basis of a large amount of historical battery charging data; the accurate SOC values of batteries of different battery types at different mileages are obtained, thus correcting the SOC value in an actual charging process of any battery on the basis of the SOC table. A more accurate SOH of the battery is further obtained on the basis of the corrected SOC value, so that the attenuation of the battery can be learned in time.

**Embodiment 6**

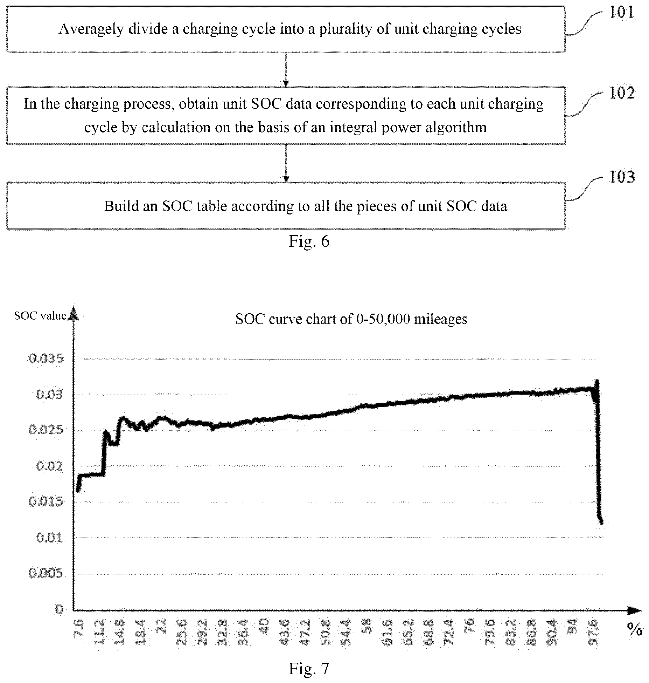

The method for obtaining the SOH of the battery in this embodiment is a further improvement on the basis of Embodiment 5. The SOC data is SOC data of a single battery in a single charging cycle. As shown in Fig. 6, the step 310 specifically includes:

In step 101, a charging cycle is averagely divided into a plurality of unit charging cycles. Specifically, the entire charging process can be divided into 250 small cycles, and each unit charging cycle accounts for 0.4%.

In step 102, in the charging process, unit SOC data corresponding to each unit charging cycle is obtained by calculation on the basis of an integral power algorithm.

It should be noted that the existing battery can automatically report the current SOC value in the charging process. In this application, in order to ensure the accuracy of the data, the SOC value can be calculated by the integrated power algorithm. If the battery power is used as the basis for data calculation, the specific calculation method can be solved by the following formula: current load voltage * current load current * time. If the battery capacity is used as the basis for data calculation, the specific calculation method can be solved by the following formula: current load current * time, or the solution is based on other better integral algorithms, which is not specifically limited in this application.

In step 103, an SOC table is built according to all the pieces of unit SOC data.

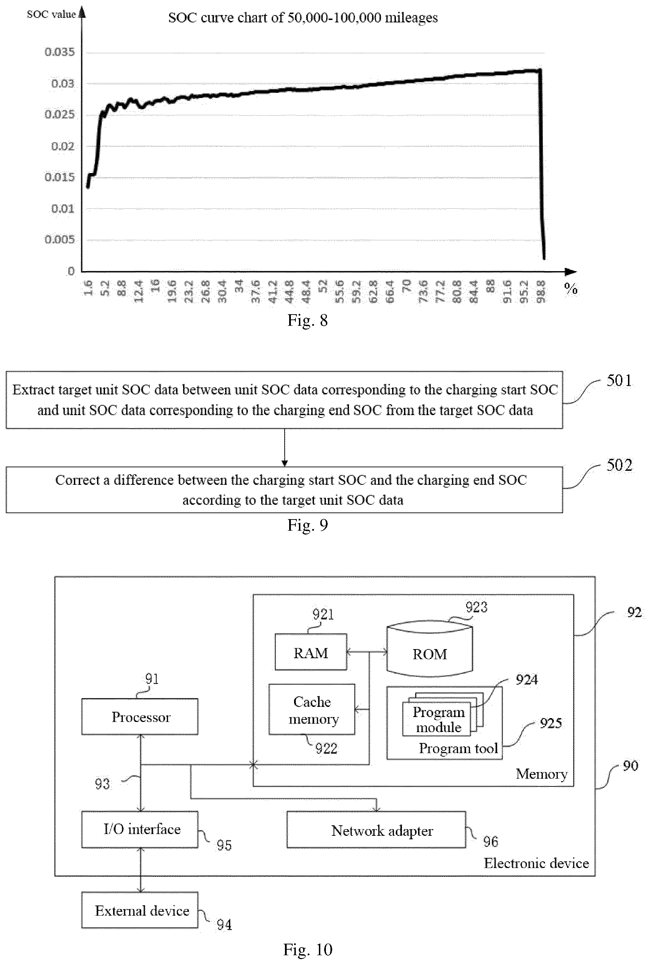

It should be noted that during the building of the SOC table, in order to more intuitively understand the SOC values of batteries of different battery models at different mileages, the SOC values can be shown in the form of a table. Specifically referring to Fig. 7 and Fig. 8 for details, SOC curve charts of a battery of a certain battery model at mileages of 0-50,000 km and 50,000-100,000 km are illustrated.

In addition, the current SOC data includes the charging start SOC and the charging end SOC. Further, as shown in Fig. 5, the step 350 specifically includes:

In step 501, target unit SOC data between unit SOC data corresponding to the charging start SOC and unit SOC data corresponding to the charging end SOC is extracted from the target SOC data.

In step 502, a difference between the charging start SOC and the charging end SOC is corrected according to the target unit SOC data.

In this embodiment, the obtaining method solves the current SOH by the following formula, which specifically includes:

$$\text{SOH}_d = \frac{Q_{charged}}{(\text{SOC}_E - \text{SOC}_S)_X} * Q_{rated}$$

$$(\text{SOC}_E - \text{SOC}_S)_X = (\text{SOC}_E - \text{SOC}_{n-1}) + (\text{SOC}_{n-1} - \text{SOC}_{n-2}) + \cdots + (\text{SOC}_1 - \text{SOC}_S)$$

where $\text{SOH}_d$ is the current SOH; Qcharged is the current charging quantity; $\text{SOC}_E$ is the charging end SOC; $\text{SOC}_S$ is the charging start SOC; $(\text{SOC}_E - \text{SOC}_S)_X$ is the corrected current SOC data; $Q_{rated}$ is a known rated power; n is the number of unit charging cycles included in the charging time period; and $\text{SOC}_{n-1}$ is a corresponding SOC of the nth unit charging cycle of the target rechargeable battery from the start of charging to the end of charging, which is obtained by querying the SOC table.

In this embodiment, a building process of the SOC table and an actual charging process of any battery are further provided to solve how to specifically correct the SOC value of any battery on the basis of the SOC table.

**Embodiment 7**

An electronic device includes a memory, a processor and a computer program stored in the memory and operable on the processor. The processor executes the computer program to the method for obtaining an SOH of a battery of Embodiment 5 or 6.

EP 4 057 019 A1

Fig. 10 is a schematic structural diagram of an electronic device provided in his embodiment. Fig. 10 shows a block diagram of an exemplary electronic device 90 suitable for implementing the implementations of the present invention. The electronic device 90 shown in Fig. 10 is only an example, and should not bring any limitation to the functions and the scope of use of the embodiments of the present invention.

As shown in Fig. 10, the electronic device 90 can be represented in the form of a general-purpose calculation device. For example, it can be a server device. Components of the electronic device 90 may include, but are not limited to, at least one processor 91, at least one memory 92, and a bus 93 connecting different system components (including the memory 92 and the processor 91).

The bus 93 includes a data bus, an address bus and a control bus.

The memory 92 may include a volatile memory, such as a random access memory (RAM) 921 and/or a cache memory 922, and may further include a read only memory (ROM) 923.

The memory 92 may also include a program tool 925 having a (at least one) group of program modules 924 including, but not limited to, an operating system, one or more application programs, other program modules, and program data. Each or a certain combination of these examples may include an implementation of a network environment.

The processor 91 executes various functional applications and data processing by operating computer programs stored in the memory 92.

The electronic device 90 may also communicate with one or more external devices 94 (such as a keyboard, a pointing device, etc.). Such communication may be carried out through an input/output (I/O) interface 95. The electronic device 90 may communicate with one or more networks (e.g., a local area network (LAN), a wide area network (WAN), and/or a public network such as the Internet) through a network adapter 96. The network adapter 96 communicates with other modules of the electronic device 90 via a bus 93. It should be understood that, although not shown, other hardware and/or software modules may be used in conjunction with the electronic device 90, including but not limited to: a microcode, a device driver, a redundant processor, an external magnetic disk drive array, an RAID (magnetic disk array) system, a magnetic tape driver, and a data backup storage system.

It should be noted that although several elements/modules or subelements/modules of the electronic device are mentioned in the above detailed description, this division is merely exemplary and not mandatory. In fact, according to the implementations of this application, the features and functions of two or more elements/modules described above may be embodied in one element/module. On the contrary, the features and functions of one element/module described above can be further embodied by multiple elements/modules.

**Embodiment 8**

A computer-readable storage medium stores a computer program. The program is executed by a processor to implement the steps of the method for obtaining an SOH of a battery of Embodiment 5 or 6.

The readable storage medium may more specifically include, but is not limited to, a portable disk, a hard disk, a random access memory, a ROM, an erasable programmable ROM, an optical storage device, a magnetic storage device, or any of the above suitable combinations.

In a possible implementation, the present invention can also be implemented in the form of a program product, which includes program codes. When the program product is operated on a terminal device, the program code is used for causing the terminal device to the steps of the method for obtaining an SOH of a battery of Embodiment 5 or 6.

The program code for implementing the present invention can be written in any combination of one or more programming languages, and the program code can be completely executed on a user equipment, partially executed on a user equipment, executed as an independent software package, partially executed on a user equipment and partially executed on a remote device, or entirely executed on a remote device.

**Embodiment 9**

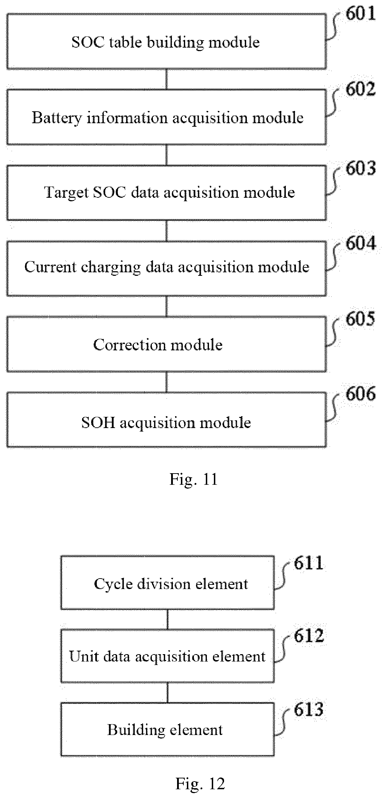

A system for obtaining an SOH of a battery, as shown in Fig. 11, includes an SOC table building module 601, a battery information obtaining module 602, a target SOC data obtaining module 603, a current charging data obtaining module 604, a correction module 605, and an SOH obtaining module 606.

The SOC table building module 601 is configured for building one SOC table, the SOC table storing SOC data of batteries of different battery models in charging processes at different mileages;

the battery information obtaining module 602 is configured for obtaining a piece of battery information of a target rechargeable battery, the battery information including a battery model and current mileage of the target rechargeable battery;

the target SOC data obtaining module 603 is configured for obtaining, according to the battery information and the SOC table, target SOC data corresponding to the target rechargeable battery;

the current charging data obtaining module 604 configured for obtaining current charging data of the target rechargeable battery within a charging time period, the current charging data including a current charging quantity and current SOC data within the charging time period.

It should be noted that both a battery power and a battery capacity can be used as the basis for data calculation, and this application does not particularly limit this. The battery power is used as the basis for data calculation for illustration in this solution of the present invention.

The correction module 605 is configured for correcting the current SOC data according to the target SOC data.

The SOH obtaining module 606 is configured for calculating a current SOH of the target rechargeable battery according to the corrected current charging data.

In this embodiment, in order to avoid a usual misunderstanding that the battery charging process is uniform, the SOC table is built on the basis of a large amount of historical battery charging data; the accurate SOC values of batteries of different battery types at different mileages are obtained, thus correcting the SOC value in an actual charging process of any battery on the basis of the SOC table. A more accurate SOH of the battery is further obtained on the basis of the corrected SOC value, so that the attenuation of the battery can be learned in time.

**Embodiment 10**

The system for obtaining an SOH of a battery of this embodiment is a further improvement on the basis of Embodiment 9. The SOC data is SOC data of a single battery in a single charging cycle. As shown in Fig. 12, the SOC table building module 601 includes a cycle division element 611, a unit data obtaining element 612 and a building element 613.

The cycle division element 611 is configured for averagely dividing a charging cycle into a plurality of unit charging cycles. Specifically, the entire charging process can be divided into 250 small cycles, and each unit charging cycle accounts for 0.4%.

The unit data obtaining element 612 is configured for respectively calculating, on the basis of an integral power algorithm, unit SOC data corresponding to each unit charging cycle in the charging process.

It should be noted that the existing battery can automatically report the current SOC value in the charging process. In this application, in order to ensure the accuracy of the data, the SOC value can be calculated by the integrated power algorithm. If the battery power is used as the basis for data calculation, the specific calculation method can be solved by the following formula: current load voltage * current load current * time. If the battery capacity is used as the basis for data calculation, the specific calculation method can be solved by the following formula: current load current * time, or the solution is based on other better integral algorithms, which is not specifically limited in this application.

The building element 613 is configured for building the SOC table according to all the unit SOC data.

It should be noted that during the building of the SOC table, in order to more intuitively understand SOC values of batteries of different battery models at different mileages, the SOC values can be shown in the form of a table.

In addition, the current SOC data includes a charging start SOC and a charging end SOC.

Further, the correction module 605 is configured for extracting target unit SOC data between unit SOC data corresponding to the charging start SOC and unit SOC data corresponding to the charging end SOC from the target SOC data; and correcting a difference between the charging start SOC and the charging end SOC according to the target unit SOC data.

In this embodiment, the obtaining system solves the current SOH by the following formula, which specifically includes:

$$SOH_d = \frac{Q_{charged}}{(SOC_E - SOC_S)_X} * Q_{rated}$$

$$(SOC_E - SOC_S)_X = (SOC_E - SOC_{n-1}) + (SOC_{n-1} - SOC_{n-2}) + \cdots + (SOC_1 - SOC_S)$$

where $SOH_d$ is the current SOH; $Q_{charged}$ is the current charging quantity; $SOC_E$ is the charging end SOC; $SOC_S$ is the charging start SOC; $(SOC_E - SOC_S)_X$ is the corrected current SOC data; $Q_{rated}$ is a known rated power; n is the number of unit charging cycles included in the charging time period; and $SOC_{n-1}$ is a corresponding SOC of the nth unit charging cycle of the target rechargeable battery from the start of charging to the end of charging, which is obtained by querying the SOC table.

In this embodiment, a building process of the SOC table and an actual charging process of any battery are further provided to solve how to specifically correct the SOC value of any battery on the basis of the SOC table.

Although the specific implementation modes of the present invention have been described above, those skilled in the art should understand that this is only an example, and the protection scope of the present invention is defined by the appended claims. Those skilled in the art can make various changes or modifications to these implementations without departing from the principle and essence of the present invention, but these changes and modifications shall all fall within the protection scope of the present invention.

**Claims**

1. A method for managing a full life cycle of a battery pack for a quick-swapping electric vehicle, **characterized by** comprising the following steps:

   receiving a battery data message sent by a station side;
   parsing the battery data message to obtain an identification code and operation information of a corresponding battery pack; and
   correspondingly storing all the pieces of received operation information on the basis of the identification code.

2. The method for managing the full life cycle of the battery pack for the quick-swapping electric vehicle according to claim 1, **characterized in that** the operation information comprises at least one of battery pack registration information, battery pack swapping information, battery pack charging information, battery pack repair information and battery pack retirement information;

   when the battery pack enters a battery swapping network for the first time, the battery pack registration information is generated at least on the basis of the identification code of the battery pack;
   when the battery pack is subjected to a battery swapping operation in the battery swapping network, corresponding battery swapping information is recorded, and the battery pack swapping information is generated;
   when the battery pack is subjected to a charging operation in the battery swapping network, corresponding charging information is obtained, and the battery pack charging information is generated;
   health information of the battery pack is obtained on the basis of the swapping information and the charging information; a battery state of the battery pack is determined on the basis of the health information: when the battery state indicates that a battery is faulted and the battery pack enters a repair flow, generating the battery pack repair information; and when the battery state is to be retired and the battery pack enters a retirement flow, generating the battery pack retirement information.

3. The method for managing the full life cycle of the battery pack for the quick-swapping electric vehicle according to claim 1, **characterized in that** the method for managing the full life cycle further comprises:
   identifying state information of each battery pack on the basis of the operation information, the state information comprising one of a normally used state, a repaired state and a retired state.

4. The method for managing the full life cycle of the battery pack for the quick-swapping electric vehicle according to claim 2, **characterized in that**

   the battery pack charging information comprises current power consumption data and charging process data;
   the method for managing the full life cycle further comprises:
   verifying the current power consumption data according to the charging process data, thus billing, on the basis of the current power consumption data, during the battery swapping.

5. The method for managing the full life cycle of the battery pack for the quick-swapping electric vehicle according to claim 2, **characterized in that** the method for managing the full life cycle further comprises:
   obtaining transfer path information of the battery pack on the basis of all the pieces of obtained battery pack swapping information of the battery pack.

6. The method for managing the full life cycle of the battery pack for the quick-swapping electric vehicle according to claim 2, **characterized in that** the method for managing the full life cycle further comprises:
obtaining state of charging information of the battery pack on the basis of all the pieces of obtained battery pack charging information of the battery pack.

7. The method for managing the full life cycle of the battery pack for the quick-swapping electric vehicle according to claim 6, **characterized in that** the step of obtaining state of charging information of the battery pack on the basis of all the pieces of obtained battery pack charging information of the battery pack comprises:

building one SOC table, the SOC table storing SOC data of batteries of different battery models in charging processes at different mileages;
obtaining a piece of battery information of a target rechargeable battery, the battery information comprising a battery model and current mileage of the target rechargeable battery;
obtaining, according to the battery information and the SOC table, target SOC data corresponding to the target rechargeable battery;
obtaining current charging data of the target rechargeable battery within a charging time period, the current charging data comprising a current charging quantity and
current SOC data within the charging time period;
correcting the current SOC data according to the target SOC data; and
calculating a current SOH of the target rechargeable battery according to the corrected current charging data.

8. The method for managing the full life cycle of the battery pack for the quick-swapping electric vehicle according to claim 7, **characterized in that** the SOC data is SOC data of a single battery under a single charging cycle, and the step of building one SOC table specifically comprises:

averagely dividing the charging cycle into a plurality of unit charging cycles;
respectively calculating, on the basis of an integral power algorithm, unit SOC data corresponding to each unit charging cycle in the charging process; and
building the SOC table according to all the unit SOC data.

9. The method for managing the full life cycle of the battery pack for the quick-swapping electric vehicle according to claim 8, **characterized in that** the current SOC data comprises a charging start SOC and a charging end SOC, and the step of correcting the current SOC data according to the target SOC data specifically comprises:

extracting target unit SOC data between unit SOC data corresponding to the charging start SOC and unit SOC data corresponding to the charging end SOC from the target SOC data; and
correcting a difference between the charging start SOC and the charging end SOC according to the target unit SOC data.

10. The method for managing the full life cycle of the battery pack for the quick-swapping electric vehicle according to claim 7, **characterized in that** the obtaining method solves the current SOH by the following formula, which specifically comprises:

$$SOH_d = \frac{Q_{charged}}{(SOC_E - SOC_S)_X} * Q_{rated}$$

$$(SOC_E - SOC_S)_X = (SOC_E - SOC_{n-1}) + (SOC_{n-1} - SOC_{n-2}) + \cdots + (SOC_1 - SOC_S)$$

where $SOH_d$ is a current SOH; $Q_{charged}$ is a current charging quantity; $SOC_E$ is a charging end SOC; $SOC_S$ is a charging start SOC; $(SOC_E - SOC_S)_X$ is a corrected current SOC data; $Q_{rated}$ is a known rated power; n is the number of unit charging cycles comprised in the charging time period; and $SOC_{n-1}$ is a corresponding SOC of the nth unit charging cycle of the target rechargeable battery from the start of charging to the end of charging, which is obtained by querying the SOC table.

11. The method for managing the full life cycle of the battery pack for the quick-swapping electric vehicle according to claim 2, **characterized in that** the station side comprises: a battery swapping station for swapping the battery pack of the electric vehicle, a charging station for charging the removed battery pack, and a repair station for repairing the battery pack.

12. A system for managing a full life cycle of a battery pack for a quick-swapping electric vehicle, **characterized by** comprising:

> a receiving module configured for receiving a battery data message sent by a station side;
> a parsing module configured for parsing the battery data message to obtain n identification code and operation information of a corresponding battery pack; and
> a storage module configured for correspondingly storing all the pieces of received operation information on the basis of the identification code.

13. A method for obtaining an SOH of a battery, **characterized by** comprising:

> building one SOC table, the SOC table storing SOC data of batteries of different battery models in charging processes at different mileages;
> obtaining a piece of battery information of a target rechargeable battery, the battery information comprising a battery model and current mileage of the target rechargeable battery;
> obtaining, according to the battery information and the SOC table, target SOC data corresponding to the target rechargeable battery;
> obtaining current charging data of the target rechargeable battery within a charging time period, the current charging data comprising a current charging quantity and
> current SOC data within the charging time period;
> correcting the current SOC data according to the target SOC data; and
> calculating a current SOH of the target rechargeable battery according to the corrected current charging data.

14. The method for obtaining the SOH of the battery according to claim 13, **characterized in that** the SOC data is SOC data of a single battery under a single charging cycle, and the step of building one SOC table specifically comprises:

> averagely dividing the charging cycle into a plurality of unit charging cycles;
> respectively calculating, on the basis of an integral power algorithm, unit SOC data corresponding to each unit charging cycle in the charging process; and
> building the SOC table according to all the unit SOC data.

15. The method for obtaining the SOH of the battery according to claim 14, **characterized in that** the current SOC data comprises a charging start SOC and a charging end SOC, and the step of correcting the current SOC data according to the target SOC data specifically comprises:

> extracting target unit SOC data between unit SOC data corresponding to the charging start SOC and unit SOC data corresponding to the charging end SOC from the target SOC data; and
> correcting a difference between the charging start SOC and the charging end SOC according to the target unit SOC data.

16. The method for obtaining the SOH of the battery according to claim 13, **characterized in that** the obtaining method solves the current SOH by the following formula, which specifically comprises:

$$SOH_d = \frac{Q_{charged}}{(SOC_E - SOC_S)_X} * Q_{rated}$$

$$(SOC_E - SOC_S)_X \\ = (SOC_E - SOC_{n-1}) + (SOC_{n-1} - SOC_{n-2}) + \cdots + (SOC_1 \\ - SOC_S)$$

where $SOH_d$ is a current SOH; $Q_{charged}$ is a current charging quantity; $SOC_E$ is a charging end SOC; $SOC_S$ is a charging start SOC; $(SOC_E - SOC_S)_X$ is a corrected current SOC data; $Q_{rated}$ is a known rated power; n is the number of unit charging cycles comprised in the charging time period; and $SOC_{n-1}$ is a corresponding SOC of the nth unit charging cycle of the target rechargeable battery from the start of charging to the end of charging, which is obtained by querying the SOC table.

17. An electronic device, **characterized by** comprising a memory, a processor, and a computer program stored in the memory and operable on the processor, wherein the processor executes the computer program to implement the method for obtaining an SOH of a battery according to any one of claims 1 to 11 and 13 to 16.

18. A computer-readable storage medium, **characterized by** storing a computer program, wherein the program is executed by a processor to implement the steps of the method for obtaining an SOH of a battery according to claims 1 to 11 and 13 to 16.

19. A system for obtaining an SOH of a battery, **characterized by** comprising an SOC table building module, a battery information obtaining module, a target SOC data obtaining module, a current charging data obtaining module, a correction module and an SOH obtaining module, wherein

the SOC table building module is configured for building one SOC table, the SOC table storing SOC data of batteries of different battery models in charging processes at different mileages;
the battery information obtaining module is configured for obtaining a piece of battery information of a target rechargeable battery, the battery information comprises a battery model and current mileage of the target rechargeable battery;
the target SOC data obtaining module is configured for obtaining, according to the battery information and the SOC table, target SOC data corresponding to the target rechargeable battery;
the current charging data obtaining module configured for obtaining current charging data of the target rechargeable battery within a charging time period, the current charging data comprises a current charging quantity and current SOC data within the charging time period;
the correction module is configured for correcting the current SOC data according to the target SOC data; and
the SOH obtaining module is configured for calculating a current SOH of the target rechargeable battery according to the corrected current charging data.

Fig. 1

| Verify the current power consumption data according to the charging process data, thus billing, on the basis of the current power consumption data, battery changing during the battery changing | S201 |

Fig. 2

| Obtain transfer path information of the battery pack on the basis of all the pieces of obtained battery pack changing information of the battery pack | S301 |

Fig. 3

System for managing a full life cycle of a battery pack of a quick-changing electric vehicle

| Receiving module 1 | Parsing module 2 | Storage module 3 | Registration information generation module 4 | Battery changing information generation module 5 | Charging information generation module 6 | Health information generation module 7 |

| Determination module 8 | State information generation module 9 | Verification module 10 | Transfer path information generation module 11 | SOH information generation module 12 |

Fig. 4

| Build an SOC table | 310 |

| Obtain battery information of a target rechargeable battery | 320 |

| Obtain target SOC data corresponding to the target rechargeable battery according to the battery information and the SOC table | 330 |

| Obtain current charging data of the target rechargeable battery within a charging time period | 340 |

| Correct the current SOC data according to the target SOC data | 350 |

| Calculate a current SOH of the target rechargeable battery according to the corrected current charging data | 360 |

Fig. 5

| | |
|---|---|
| Averagely divide a charging cycle into a plurality of unit charging cycles | 101 |

| | |
|---|---|
| In the charging process, obtain unit SOC data corresponding to each unit charging cycle by calculation on the basis of an integral power algorithm | 102 |

| | |
|---|---|
| Build an SOC table according to all the pieces of unit SOC data | 103 |

Fig. 6

SOC value

SOC curve chart of 0-50,000 mileages

Fig. 7

SOC value ▲      SOC curve chart of 50,000-100,000 mileages

Fig. 8

| Extract target unit SOC data between unit SOC data corresponding to the charging start SOC and unit SOC data corresponding to the charging end SOC from the target SOC data | 501 |

| Correct a difference between the charging start SOC and the charging end SOC according to the target unit SOC data | 502 |

Fig. 9

Fig. 10

SOC table building module — 601

Battery information acquisition module — 602

Target SOC data acquisition module — 603

Current charging data acquisition module — 604

Correction module — 605

SOH acquisition module — 606

Fig. 11

Cycle division element — 611

Unit data acquisition element — 612

Building element — 613

Fig. 12

## INTERNATIONAL SEARCH REPORT

| | International application No. |
|---|---|
| | **PCT/CN2020/142035** |

### A.   CLASSIFICATION OF SUBJECT MATTER

G01R 31/392(2019.01)i;   B60L 58/16(2019.01)i;   B60L 58/12(2019.01)i

According to International Patent Classification (IPC) or to both national classification and IPC

### B.   FIELDS SEARCHED

Minimum documentation searched (classification system followed by classification symbols)

G01R; B60L

Documentation searched other than minimum documentation to the extent that such documents are included in the fields searched

Electronic data base consulted during the international search (name of data base and, where practicable, search terms used)

CNPAT, CNKI, WPI, EPODOC: ( 荷电 or 电荷 or 充电 ) w 状态, 健康状态 or 劣化率, 积分 or 微分 or 分段 or 小段 or 周期, 修正 or 校正 or 校准 or 计算 or 估算, 电池, 入网 or 注册 or 登记 or 识别码, 生命 or 周期 or 寿命 or 全, ( 充电 or 换电 or 维修 ) 4d ( 站 or 桩 ), 记录 or 上传 or 存储 or 记载 or 管理 or 追踪 or 跟踪, 老化 or 退化 or 退役, batter+, SOC or ( state 6d charg??? ), SOH or ( state 6d health+ ), age+ or deteriorat+, table?, estimat+ or amend+ or correct+, id or identif+

### C.   DOCUMENTS CONSIDERED TO BE RELEVANT

| Category* | Citation of document, with indication, where appropriate, of the relevant passages | Relevant to claim No. |
|---|---|---|
| X | CN 105667464 A (NEXTEV LIMITED) 15 June 2016 (2016-06-15)<br>description, paragraphs [0004]-[0006], [0034]-[0041], figures 1-3 | 1-6,11,12 |
| X | CN 109997050 A (JOHNSON CONTROLS TECH CO et al.) 09 July 2019 (2019-07-09)<br>description, paragraphs [0030]-[0070], and figures 2-5,8 | 13-16,19 |
| Y | CN 105667464 A (NEXTEV LIMITED) 15 June 2016 (2016-06-15)<br>description, paragraphs [0004]-[0006], [0034]-[0041], figures 1-3 | 7-10,17,18 |
| Y | CN 109997050 A (JOHNSON CONTROLS TECH CO et al.) 09 July 2019 (2019-07-09)<br>description, paragraphs [0030]-[0070], and figures 2-5,8 | 7-10,17,18 |
| A | CN 107249923 A (AUDI AG) 13 October 2017 (2017-10-13)<br>entire document | 1-19 |
| A | CN 107024659 A (GM GLOBAL TECHNOLOGY OPERATIONS LLC.) 08 August 2017 (2017-08-08)<br>entire document | 1-19 |
| A | CN 110203105 A (JIMEI UNIVERSITY) 06 September 2019 (2019-09-06)<br>entire document | 1-19 |

☑ Further documents are listed in the continuation of Box C.   ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **09 March 2021** | **26 March 2021** |

| Name and mailing address of the ISA/CN | Authorized officer |
|---|---|
| **China National Intellectual Property Administration (ISA/CN)**<br>**No. 6, Xitucheng Road, Jimenqiao, Haidian District, Beijing 100088**<br>**China** | |
| Facsimile No. **(86-10)62019451** | Telephone No. |

Form PCT/ISA/210 (second sheet) (January 2015)

## INTERNATIONAL SEARCH REPORT

| | International application No. |
|---|---|
| | **PCT/CN2020/142035** |

**C. DOCUMENTS CONSIDERED TO BE RELEVANT**

| Category* | Citation of document, with indication, where appropriate, of the relevant passages | Relevant to claim No. |
|---|---|---|
| A | CN 109455107 A (HUNAN MIAOCHONG NEW ENERGY TECHNOLOGY CO., LTD.) 12 March 2019 (2019-03-12)<br>    entire document | 1-19 |
| A | US 2010138178 A1 (TESLA MOTORS, INC.) 03 June 2010 (2010-06-03)<br>    entire document | 1-19 |
| A | US 2011148424 A1 (INDUSTRIAL TECHNOLOGY RESEARCH INSTITUTE) 23 June 2011 (2011-06-23)<br>    entire document | 1-19 |

Form PCT/ISA/210 (second sheet) (January 2015)

<table>
<tr><td colspan="4" align="center">INTERNATIONAL SEARCH REPORT<br>Information on patent family members</td><td>International application No.<br><br>**PCT/CN2020/142035**</td></tr>
<tr><td colspan="2" align="center">Patent document<br>cited in search report</td><td align="center">Publication date<br>(day/month/year)</td><td align="center">Patent family member(s)</td><td align="center">Publication date<br>(day/month/year)</td></tr>
<tr><td colspan="2">CN   105667464   A</td><td>15 June 2016</td><td>EP   3431324   A1</td><td>23 January 2019</td></tr>
<tr><td colspan="2"></td><td></td><td>US   2020198494   A1</td><td>25 June 2020</td></tr>
<tr><td colspan="2"></td><td></td><td>WO   2017157245   A1</td><td>21 September 2017</td></tr>
<tr><td colspan="2">CN   109997050   A</td><td>09 July 2019</td><td>US   10300807   B2</td><td>28 May 2019</td></tr>
<tr><td colspan="2"></td><td></td><td>EP   3507613   A1</td><td>10 July 2019</td></tr>
<tr><td colspan="2"></td><td></td><td>US   2017225584   A1</td><td>10 August 2017</td></tr>
<tr><td colspan="2"></td><td></td><td>WO   2018044346   A1</td><td>08 March 2018</td></tr>
<tr><td colspan="2">CN   107249923   A</td><td>13 October 2017</td><td>EP   3259799   B1</td><td>08 April 2020</td></tr>
<tr><td colspan="2"></td><td></td><td>DE   102015002154   A1</td><td>18 August 2016</td></tr>
<tr><td colspan="2"></td><td></td><td>US   2018009328   A1</td><td>11 January 2018</td></tr>
<tr><td colspan="2"></td><td></td><td>KR   20170117118   A</td><td>20 October 2017</td></tr>
<tr><td colspan="2"></td><td></td><td>CN   107249923   B</td><td>12 June 2020</td></tr>
<tr><td colspan="2"></td><td></td><td>EP   3259799   A1</td><td>27 December 2017</td></tr>
<tr><td colspan="2"></td><td></td><td>KR   101940437   B1</td><td>18 January 2019</td></tr>
<tr><td colspan="2"></td><td></td><td>WO   2016131823   A1</td><td>25 August 2016</td></tr>
<tr><td colspan="2">CN   107024659   A</td><td>08 August 2017</td><td>CN   107024659   B</td><td>28 April 2020</td></tr>
<tr><td colspan="2"></td><td></td><td>DE   102016119253   A1</td><td>20 April 2017</td></tr>
<tr><td colspan="2"></td><td></td><td>US   2016039419   A1</td><td>11 February 2016</td></tr>
<tr><td colspan="2">CN   110203105   A</td><td>06 September 2019</td><td align="center">None</td><td></td></tr>
<tr><td colspan="2">CN   109455107   A</td><td>12 March 2019</td><td align="center">None</td><td></td></tr>
<tr><td colspan="2">US   2010138178   A1</td><td>03 June 2010</td><td>US   8004243   B2</td><td>23 August 2011</td></tr>
<tr><td colspan="2">US   2011148424   A1</td><td>23 June 2011</td><td>TW   201122523   A</td><td>01 July 2011</td></tr>
<tr><td colspan="2"></td><td></td><td>TW   I411796   B</td><td>11 October 2013</td></tr>
</table>

Form PCT/ISA/210 (patent family annex) (January 2015)

**EP 4 057 019 A1**

**Patent documents cited in the description**

- CN 201911413797
- CN 201911068427